# EUROPÄISCHE PATENTSCHRIFT

(11) **EP 0 423 154 B1**
(45) Veröffentlichungstag und Bekanntmachung des Hinweises auf die Patenterteilung: **22.09.1993**
(21) Anmeldenummer: 89906719.3
(22) Anmeldetag: 16.06.1989
(51) Int. Cl.: G01N 23/227

(54) **VERFAHREN UND VORRICHTUNG ZUR UNTERSUCHUNG VON STRUKTUREN AUF MEMBRANOBERFLÄCHEN**
METHOD AND APPARATUS FOR THE EXAMINATION OF STRUCTURES ON MEMBRANE SURFACES
PROCEDE ET DISPOSITIF POUR L'EXAMEN DE STRUCTURES SUR DES SURFACES MEMBRANAIRES

(30) Priorität: 16.06.1988 DE 3820549
(43) Veröffentlichungstag der Anmeldung: 24.04.1991
(73) Patentinhaber: FRAUNHOFER-GESELLSCHAFT ZUR FÖRDERUNG DER ANGEWANDTEN FORSCHUNG E.V., 80636 München (DE)
(72) Erfinder: BRÜNGER, Wilhelm, D-1000 Berlin 38 (DE)
(74) Vertreter: Münich, Wilhelm, Dr.
(86) Internationale Anmeldenummer: DE8900398
(87) Internationale Veröffentlichungsnummer: WO8912818

(56) Entgegenhaltungen:
- DE-A- 2 213 719
- US-A- 2 418 228
- US-A- 4 459 482
- Patent Abstracts of Japan, vol. 1, No. 127 (E-77)(5566), 21 October 1977 & Jp, A, 5260686
- Optik, vol. 44, No. 4, March 1976, Wissenschaftliche Verlagsgesellschaft mbH (Stuttgart, DE), H. Seiler et al.: "Materialanalyse an dünnen Folien mittels Augerelektronen-Spektroskopie", pages 505-507, see the whole article

## Beschreibung

### Technisches Gebiet

Die Erfindung betrifft ein Verfahren und eine Vorrichtung zur Untersuchung von Strukturen mit Breiten von einigen Mikrometern auf Membranoberflächen.

Mit der zunehmenden Miniaturisierung der Strukturen mikroelektronischer Schaltungen und mikromechanischer Komponenten gewinnt die Analyse feinster Strukturen (im µ- und sub-µ-Bereich) mit hoher Auflösung an technischer Bedeutung.

Für die Oberflächenanalyse hat sich in der Praxis die Elektronenspektroskopie bewährt. Der prinzipielle Aufbau von Apparaturen für die Elektronenspektroskopie sind beschrieben in der Veröffentlichung von Wannberg, B., Gelius, U. und Siegbahn, K. "Design prinziples in electron spectroscopy" in Journal of Physics E, Bd. 7 (1974) S. 149-159. In dieser Schrift werden die drei prinzipiellen Möglichkeiten für die Erzeugung der zu untersuchenden Elektronen genannt. Die Elektronen können mit einer Röntgenstrahlenquelle, oder mit einer UV-Lichtquelle oder mit einem primären Elektronenstrahl an der Probenoberfläche erzeugt werden.

### Stand der Technik

Üblicherweise erfolgt die Oberflächenanalyse von Mikrostrukturen wegen der guten Fokussierbarkeit von Elektronenstrahlen mit Hilfe des Auger-Effekts (electron-induced Auger Electron Spectroscopy, e⁻AES). "Die Materialanalyse an dünnen Folien mittels Augerelektronen-Spektroskopie" wurde von H. Seiler und P. Wiedmann in einem Fachartikel in Optik, Bd. 44 (1976), S. 505-507 beschrieben. Die Nachteile dieser Methode liegen darin, daß die zu untersuchende Struktur hohen Belastungen ausgesetzt ist, wodurch zahlreiche Strahlenschäden in der Probe erzeugt werden und daß sie nicht auf isolierende Substanzen angewendet werden kann.

Beide Nachteile werden vermieden, wenn die Auslösung der Elektronen mit Hilfe von Röntgenstrahlen erfolgt (x-ray photoelectron spectroscopy, XPS). Gleichzeitig liefert dieses Verfahren Informationen über den Bindungszustand an der Festkörperoberfläche.

Allerdings können Röntgenstrahlen nicht so einfach fokussiert werden wie Elektronenstrahlen, weshalb dieses Verfahren ein wesentlich schlechteres räumliches Auflösungsvermögen mit sich bringt und deshalb zur Untersuchung feinster Strukturen wenig geeignet ist.

Das Auflösungsvermögen des XPS-Verfahrens kann dadurch verbessert werden, daß die Röntgenstrahlen in einem räumlich sehr begrenzten Gebiet erzeugt werden. Dazu wird ein primärer Elektronenstrahl auf die Rückseite einer Membrane fokussiert, der in der Membrane Röntgenstrahlen freisetzt. Die freigesetzten Röntgenstrahlen, die auf der Vorderseite der Membrane austreten, stellen eine räumlich eng begrenzte Röntgenquelle dar. Wegen der Absorption der Röntgenstrahlen in der Membrane müssen bei diesem Verfahren dünne Membranen (einige Mikrometer) verwendet werden. Die lokalen Röntgenquellen setzen an der Membranoberfläche lokal Photoelektronen frei, die mit Hilfe von Spektrometern analysiert werden. Wegen der geringen Austrittstiefe der Photoelektronen werden nur die obersten Atomlagen erfaßt.

Ein solches hochauflösendes XPS-Verfahren wurde von J. Cazaux angegeben (Microanalyse et Microscopie Photoélectroniques X: Principe et performances prévisibles, Revue de Physique Appliquée, 1975, S. 263 - 280) und von C.T. Hovland ausgeführt (Scanning ESCA: A new discussion for electron spectroscopy, Applied Physics Letters, Vol. 30, 1977, S. 274 - 275). Das Verfahren wird auch kurz in Patent Abstracts of Japan, Band 1, Nr. 127 (E-77) (5566), 12. Oktober 1977, beschrieben. Bei den bekannten hochauflösenden XPS-Verfahren können allerdings die von den Röntgenquanten ausgelösten Photoelektronen nur in der Verlängerung der Richtung der einfallenden Primärelektronen vom Spektrometer abgenommen werden. Diese Winkelkonfiguration ist in kommerziellen Auger-Sonden nicht realisierbar, weshalb für die Anwendung dieser Methode spezielle Meßapparaturen gebaut werden müssen.

### Darstellung der Erfindung

Der Erfindung liegt die Aufgabe zugrunde, die hochauflösende XPS-Methode so weiterzuentwickeln, daß sie in kommerziellen Auger-Sonden angewendet werden kann.

Diese Aufgabe wird erfindungsgemäß mit dem im Anspruch 1 gekennzeichneten Verfahren gelöst.

Eine weitere Aufgabe der Erfindung ist es, eine kommerzielle Auger-Sonde so weiterzuentwickeln, daß sie sich zur Ausführung des erfindungsgemäßen Verfahrens eignet.

Diese Aufgabe wird mit der im Anspruch 6 gekennzeichneten Vorrichtung gelöst.

Vorteilhafte Ausgestaltungen der Erfindung sind in den Unteransprüchen gekennzeichnet.

Um eine kommerzielle Auger-Apparatur möglichst geringfügig verändern zu müssen, kann die Probe nach Anspruch 2 so gehaltert werden, daß die zu untersuchende Mikrostruktur auf der Membranoberfläche etwa in der Winkelhalbierenden zwischen dem einfallenden Elektronenstrahl und der Spektrometerachse liegt. Damit bleibt die Strahlgeometrie der Auger-Anordnung erhalten.

Eine vorteilhafte Ausgestaltung des Verfahrens ist in Anspruch 3 gekennzeichnet. Damit das Meßsignal möglichst wenig durch Hintergrundstrahlung gestört wird, wird das Verfahren so durchgeführt, daß die aus der Rückseite der Membrane emittierten Sekundärelektronen zurückgehalten werden, so daß sie nicht auf das Spektrometer treffen können.

Nach Anspruch 4 wird die Energie der Elektronen des Primärstrahls so weit herabgesetzt, daß weder gestreute noch ungestreute Elektronen die Membrane durchdringen. Damit treten aus der Membranvorderseite keine Elektronen des Primärstrahles aus, die das Meßergebnis verfälschen könnten. Es ist dadurch auch sichergestellt, daß an der Probenoberfläche nur Anregung durch Röntgenstrahlung und nicht durch Elektronen stattfinden kann.

Das Verfahren ist nach Anspruch 5 auch sehr gut zur Erzeugung eines üblichen Elektronenrasterbildes (SEM-Bild) geeignet. Dafür wird die Energie der Elektronen des gerasterten Primärstrahls so weit erhöht, daß aus der Vorderseite der Membrane sowohl Primär- als auch Sekundärelektronen austreten, die zur Abbildung der Struktur verwendet werden.

In Anspruch 6 ist eine besonders geeignete Vorrichtung zur Durchführung des Verfahrens gekennzeichnet. Der Probenhalter weist einen Kanal auf, der als Faraday-Käfig wirkt, wodurch die aus der Rückseite der Membrane austretenden Elektronen zurückgehalten werden.

Mit der in Anspruch 7 gekennzeichneten Ausgestaltung des Probenhalters wird erreicht, daß die Probe in der Winkelhalbierenden zwischen dem einfallenden Elektronenstrahl und der Spektrometerachse liegt. Dadurch kann die in Auger-Apparaturen übliche Anordnung von Elektronenquelle und Spektrometer beibehalten werden. Nach Anspruch 8 beträgt der Winkel entsprechend dem Winkel zwischen einfallendem Elektronenstrahl und der Spektrometerachse 60°.

Bei einer vorteilhaften Weiterbildung nach Anspruch 9 ist der Probenhalter um eine Achse drehbar, die den Winkel zwischen den beiden Flächen, in denen die Kanalöffnungen liegen, halbiert. Durch Drehung der Probe um 180° kann die Apparatur aus dem Modus der hochauflösenden XPS-Untersuchung einfach in den Modus der Auger-Elektronen Untersuchung gebracht werden.

Um für die Messung ein maximales Signal im Spektrometer zur Verfügung zu haben, können nach Anspruch 10 durch Kippen des Probenhalters Einfallswinkel und Beobachtungsrichtung optimiert werden.

Um den Faraday-Effekt zu gewährleisten, muß wenigstens die Wand des Kanals mit einer leitfähigen Substanz beschichtet sein. Bei einer besonders einfachen Ausgestaltung ist der Probenhalter nach Anspruch 11 ganz aus Metall, vorzugsweise aus Aluminium gefertigt.

Die mit der Erfindung erzielten Vorteile bestehen insbesondere darin, daß mit Hilfe einer kommerziellen Auger-Apparatur XPS-Messungen mit hoher Auflösung durchgeführt werden können. Dabei werden die Vorteile der Auger-Methode, insbesondere die hohe Auflösung, kombiniert mit den Vorteilen der XPS-Methode, so daß nahezu alle Strukturen untersucht werden können und auf der Probe weniger Strahlenschäden entstehen.

Das Verfahren eignet sich für Untersuchungen von Masken für die Röntgenlithographie sowie von allen Mikrostrukturen auf Membranen aus dem Bereich der Mikromechanik und von biologischen Substanzen, die sich auf Membranen präparieren lassen.

### Kurze Beschreibung der Zeichnungen

Je ein Ausführungsbeispiel für das Verfahren zur Untersuchung von Strukturen auf Membranoberflächen und für den Probenhalter zu seiner Ausführung sind in den Zeichnungen dargestellt und werden im folgenden näher beschrieben.

Es zeigen:
- Fig. 1a: die schematische Darstellung einer Apparatur für Auger-Untersuchungen;
- Fig. 1b: die schematische Darstellung einer Apparatur für XPS-Untersuchungen;
- Fig. 2a: die schematische Darstellung der erfindungsgemäßen Apparatur für XPS-Untersuchungen;
- Fig. 2b: die schematische Darstellung der Vorgänge in der Probe;
- Fig. 3: die Punktanalyse eines transparenten Bereichs einer Röntgenmaske;
- Fig. 4a: die Rasterabbildung einer Goldabsorberstruktur;
- Fig. 4b: die Rasterabbildung einer Goldabsorberstruktur;
- Fig. 5: das Linienraster über eine Silizum-Goldkante;
- Fig. 6: den Querschnitt durch den Probenhalter für XPS-Untersuchungen;
- Fig. 7: die dreidimensionale Darstellung des Probenhalters.

### Wege zur Ausführung der Erfindung

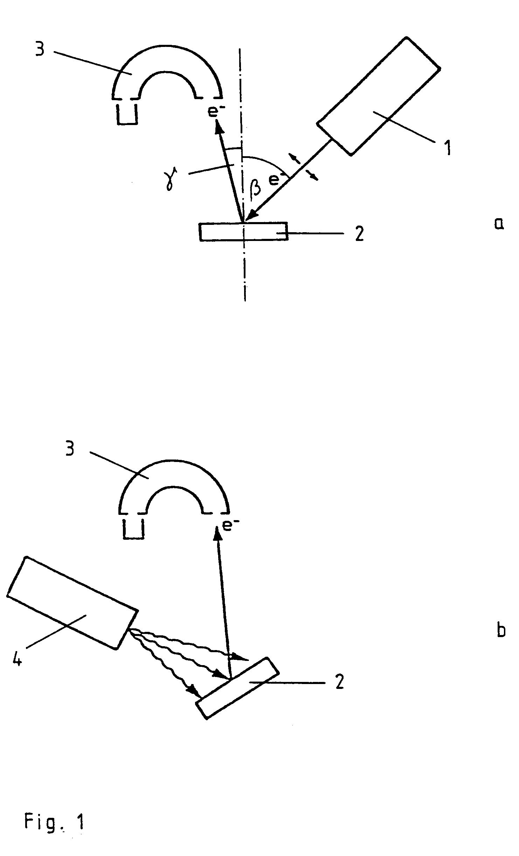

In den Figuren sind Elektronenstrahlen als gerade Pfeile dargestellt und mit e- bezeichnet, gewellte Pfeile stellen Röntgenstrahlen dar. In Fig. 1 sind zwei bekannte Methoden zur Untersuchung von Oberflächen schematisch dargestellt. Bei Auger-Untersuchungen gemäß Fig. 1a trifft ein Elektronenstrahl aus einer Elektronenquelle 1 unter einem Winkel β auf die Oberfläche der Probe 2. Mit Hilfe eines Photoelektronen-Spektrometers 3 werden die Sekundärelektronen analysiert, die unter einem Winkel γ aus der Probenoberfläche austreten. Diese Beobachtungsrichtung stimmt mit der Achse des Photoelektronenspektrometers überein.

Bei XPS-Untersuchungen werden die beobachteten Photoelektronen durch Röntgenquanten aus der Probenoberfläche gelöst. In Fig. 1b ist angedeutet, daß die Röntgenstrahlen, die aus der Röntgenquelle 4 emittiert werden, schlecht fokussiert sind.

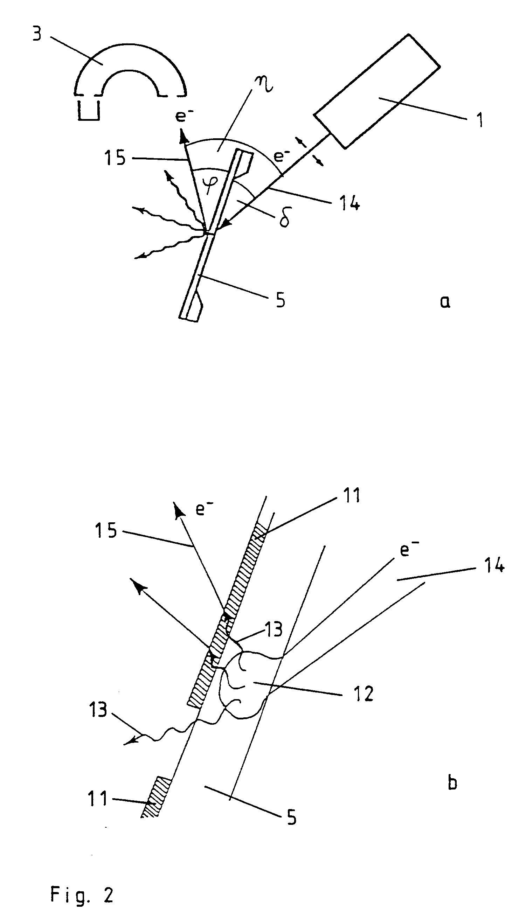

Bei dem erfindungsgemäßen Verfahren, das in Fig. 2a und Fig. 2b veranschaulicht ist, trifft der Primärelektronenstrahl 14 aus der Elektronenquelle 1 unter einem Winkel δ auf die Rückseite einer Membrane 5 (Dicke beispielsweise 2 µm), auf deren Vorderseite die zu untersuchende Struktur 11 (Dicke beispielsweise einige 10 nm), - im Fall dieses Ausführungsbeispiels eine Röntgenmaske - aufgebracht ist. Der Elektronenstrahl induziert in der Si-Membrane eine Röntgenstrahlung 13, in diesem Beispiel wird die SiK_{α} Strahlung zur Anregung herangezogen. Da der Elektronenstrahl sehr fein gebündelt werden kann, ist die durch den Elektronenstrahl erzeugte Röntgenstrahlung räumlich auf einen sehr engen Bereich 12 begrenzt, wodurch eine hohe Ortsauflösung erreicht wird. Die Röntgenstrahlung löst in einem räumlich eng begrenzten Bereich auf der Membranoberfläche Photoelektronen 15 aus. Diejenigen Photoelektronen, die unter einem bestimmten Winkel φ aus der Membranvorderseite austreten, werden zur Analyse der Struktur mit Hilfe eines Photoelektronen-Spektrometers 3 untersucht.

Mit dem erfindungsgemäßen Verfahren werden nur die durch Röntgenstrahlen ausgelösten Photoelektronen mit einer Austrittstiefe von wenigen Atomlagen analysiert. Die Primär- und Streuelektronen des auf der Membranrückseite einfallenden Elektronenstrahls werden mit Hilfe des erfindungsgemäßen Verfahrens unter Verwendung des erfindungsgemäßen Probenhalters wirkungsvoll vom Photoelektronen-Spektrometer ferngehalten.

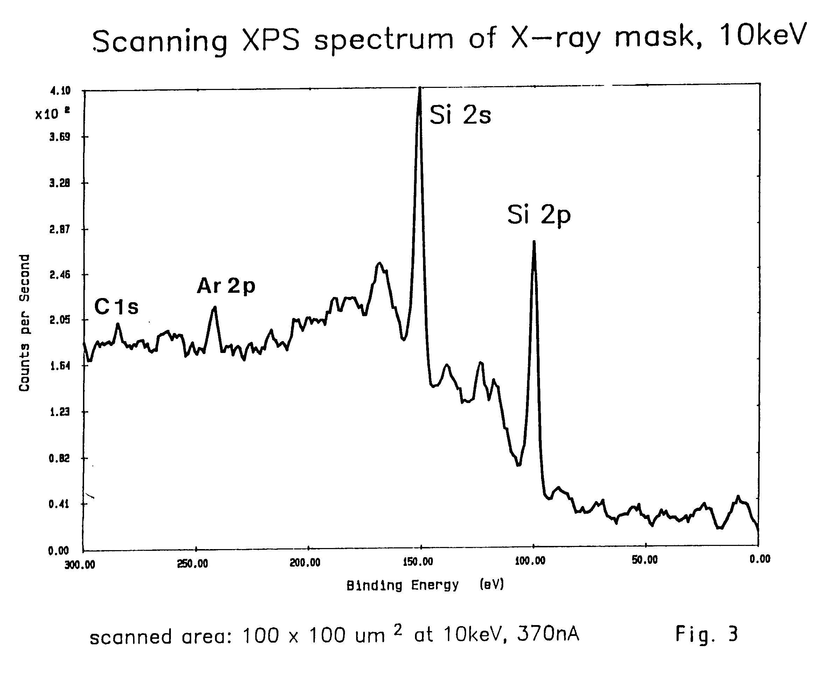

Fig. 3 zeigt die Punktanalyse eines transparenten Bereichs der Röntgenmaske. Die Intensität des Photoelektronenstrahls (vertikale Achse) ist über der Energie der Photoelektronen (horizontale Achse) aufgetragen. Neben den beiden Intensitätsmaxima (Si2s, Si2p), die von zwei unterschiedlichen elektronischen Niveaus im Silizium verursacht werden, sind zwei relative Maxima zu erkennen, die in ihrer Energie mit Linien aus dem Elektronenspektrum von Kohlenstoff (C) bzw. Argon (Ar) übereinstimmen. Damit wird die Verunreinigung mit Kohlenstoff- und Argonatomen sichtbar, die nach Sputtern der Membranoberfläche noch zurückbleibt. Gleichzeitig wird damit die Leistungsfähigkeit dieses Verfahrens bewiesen, Spurenelemente auf der Oberfläche zu analysieren.

Mit dem Primärelektronenstrahl wird auf der Rückseite der Membrane eine Fläche von bis zu 500 x 500 Mikrometer abgerastert. Dadurch kann ein entsprechend großer Bereich der Struktur auf der Membranoberfläche untersucht werden. Die Größe der Fläche in diesem Ausführungsbeispiel stellt keine Einschränkung dar, da die Ausmaße des Probenhalters so groß gewählt werden können, daS die gesamte Membranoberfläche erfaßt wird.

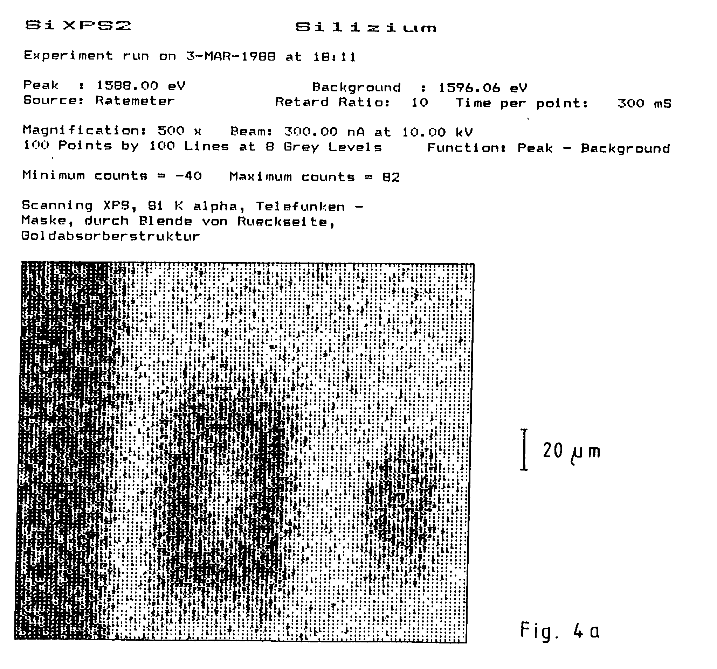

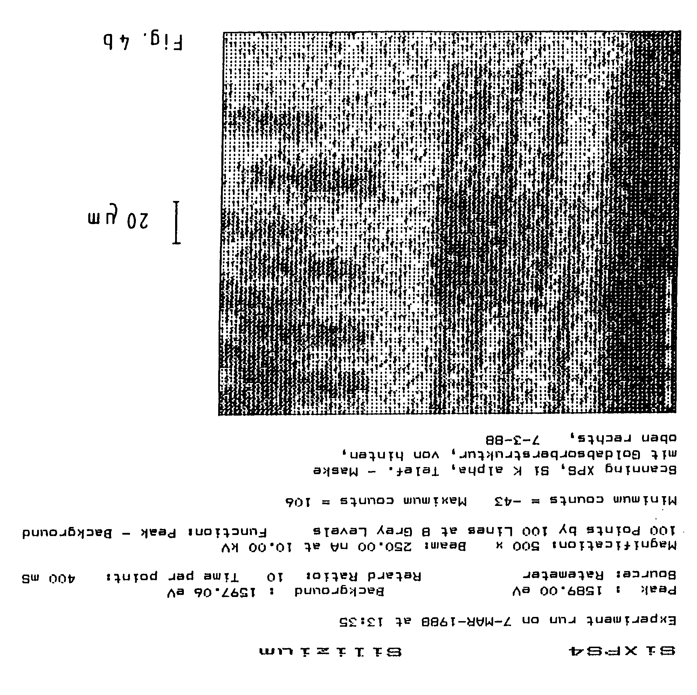

In Fig. 4a und 4b sind Rasterabbildungen von Strukturen dargestellt, die mit Hilfe von Photoelektronen der Energie von 1588 eV (Si2s - Maximum) geschrieben wurden.

Mit Hilfe eines Linienrasters über die Kante einer Struktur wird das Auflösungsvermögen des Verfahrens verdeutlicht.

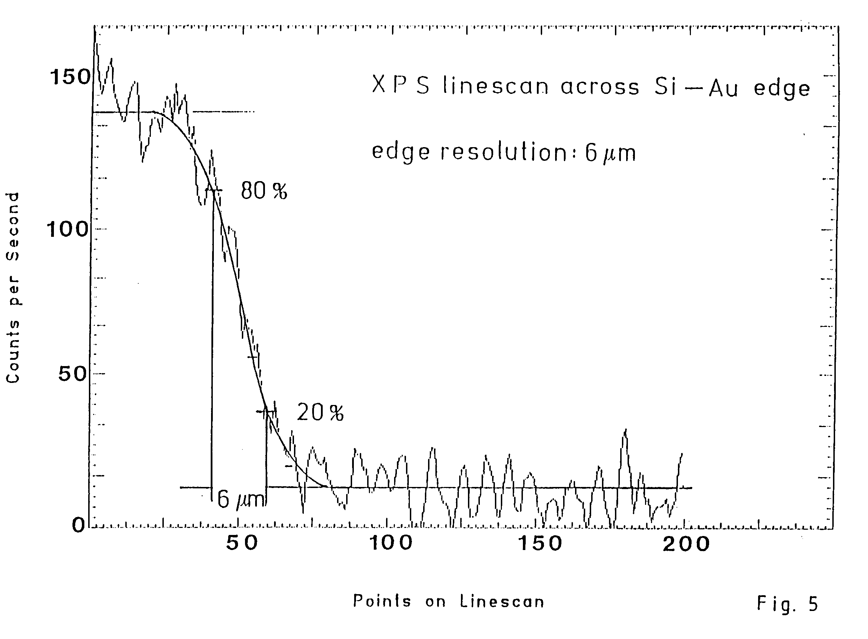

Fig. 5 zeigt die Intensität des Meßsignales entlang einer Silizium-Gold-Kante. Die Auflösungsgrenze beträgt 6 µm und liegt deutlich unter der bisher mit XPS-Verfahren erreichten Auflösung von 40 µ m.

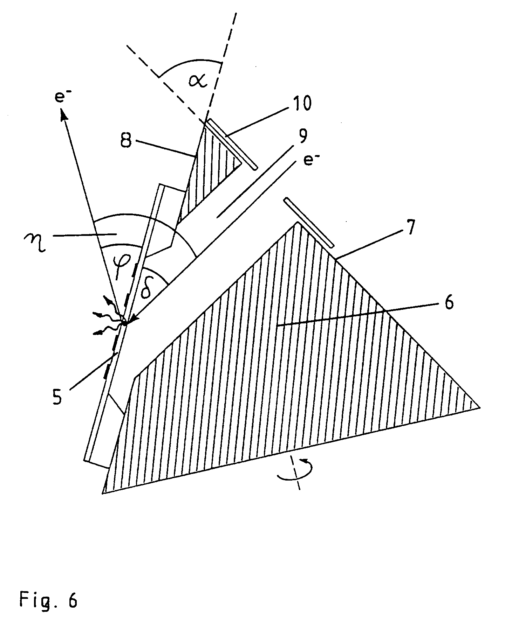

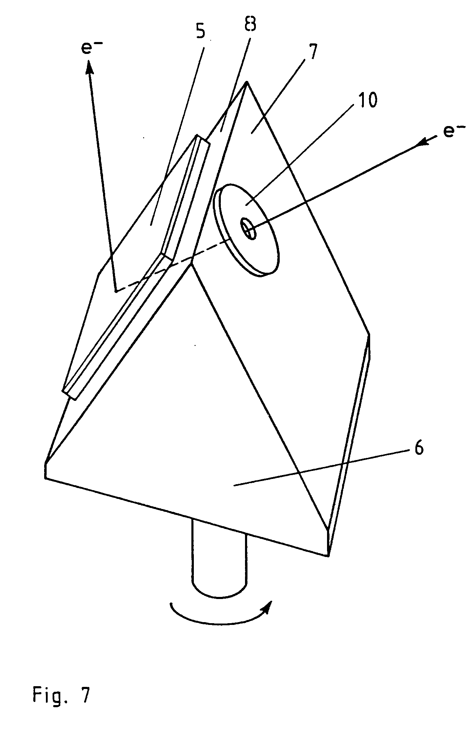

Der Probenhalter (Fig. 6 und Fig. 7) zur Durchführung des beschriebenen Verfahrens besteht aus einem Grundkörper 6 aus Aluminium, der zwei gegeneinander geneigte Flächen 7, 8 aufweist. Der Winkel α, den die beiden Flächen 7, 8 einschliessen, entspricht dem Winkel η (Fig. 2a) zwischen dem einfallenden Elektronenstrahl und der Beobachtungsrichtung (Spektrometerachse) . Die Geometrie des Probenhalters ist so gewählt, daß die zu untersuchende Oberfläche diesen Winkel η halbiert. Die Winkel δ und φ sind annähernd gleich groß.

Der Grundkörper ist von einem Kanal 9 durchdrungen, der die beiden Flächen 7, 8 mit Öffnungen versieht. Die Öffnung, die in Richtung des einfallenden Elektronenstrahls weist, ist mit einer Blende 10 (Durchmesser etwa 1 mm) teilweise abgedeckt, während vor der gegenüberliegenden Öffnung die Membran 5 mit der zu untersuchenden Struktur 11 angebracht ist.

Der Probenhalter mit dem als Faraday-Käfig wirkenden Kanal 9 gewährleistet, daß Sekundärelektronen, die durch Auftreffen des primären Elektronenstrahles auf die Membrane entstehen, nicht auf das Spektrometer treffen. Die störende Hintergrund-Strahlung wird dadurch auf ein Minimum reduziert.

Die spezielle Geometrie des Probenhalters bewirkt, daß der einfallende Elektronenstrahl und die Spektrometerachse, die die Beobachtungsrichtung der durch die Röntgenstrahlen erzeugten Photoelektronen bestimmt, einen Winkel einschließen, der es erlaubt, die hochauflösende XPS-Methode mit einer herkömmlichen Auger-Apparatur durchzuführen.

Der Probenhalter hat eine Kantenlänge von einigen Zentimetern, der Kanaldurchmesser beträgt etwa 1 mm. Der Probenhalter ist um seine Figurenachse drehbar, um mit unveränderter Anordnung auch Untersuchungen nach der Auger-Methode durchführen zu können.

Für die Untersuchung größerer Flächen (Membranoberflächen von einigen cm Durchmesser) kann der Probenhalter auch wesentlich größer ausgeführt werden.

## Patentansprüche

1. Verfahren zur Untersuchung von Membranoberflächen mit Hilfe der Photoelektronenspektroskopie (XPS), wobei durch Einstrahlen eines primären Elektronenstrahls (14) aus einem lokalen Bereich der zu untersuchenden Membrane (5) Röntgenstrahlen freigesetzt werden, die ihrerseits Photoelektronen (15) auslösen, die mit Hilfe eines Spektrometers (3) analysiert werden, dadurch **gekennzeichnet**, daß der Primär-Elektronenstrahl (14) unter einem vorgebbaren, wesentlich von 90° verschiedenen, ersten Winkel (δ) auf die Rückseite der Membrane (5) auftrifft und die Photoelektronen, die aus der Membranvorderseite austreten, unter einem vorgebbaren, wesentlich von 90° verschiedenen, zweiten Winkel (φ) beobachtet werden, so daß der Winkel zwischen dem einfallenden Elektronenstrahl (14) und der Beobachtungsrichtung (η) wesentlich kleiner als 180° ist.

2. Verfahren nach Anspruch 1, dadurch **gekennzeichnet**, daß der Eintrittswinkel des Primärelektronenstrahls und der Beobachtungswinkel für die sekundären Photoelektronen annähernd übereinstimmen.

3. Verfahren nach den Ansprüchen 1 und 2, dadurch **gekennzeichnet**, daß die aus der Rückseite der Membrane (5) emittierten Sekundärelektronen zurückgehalten werden, so daß sie nicht auf das Spektrometer (3) treffen.

4. Verfahren nach einem der Ansprüche 1 bis 3, dadurch **gekennzeichnet**, daß die Elektronenergie des Primärstrahls (14) soweit herabgesetzt ist, daß aus der Membran-Vorderseite keine Elektronen des Primärstrahls austreten können.

5. Verfahren nach einem der Ansprüche 1 bis 3, dadurch **gekennzeichnet**, daß die Elektronenergie des Primärstrahls (14) so weit erhöht ist, daS aus der Vorderseite der Membrane (5) Primärelektronen und Sekundärelektronen (15) austreten, die zur Erzeugung eines normalen Elektronenrasterbildes herangezogen werden können.

6. Vorrichtung zur Durchführung des Verfahrens nach einem der Ansprüche 1 bis 5 bestehend aus einer Apparatur zur Messung von Auger-Elektronen mit einer Elektronenquelle (1) und einem Photoelektronen-Spektrometer (3), wobei die Richtung des aus der Elektronenquelle stammenden Strahles und die Beobachtungsrichtung einen Winkel (η) einschließen der wesentlich kleiner als 180° ist, und einem Probenhalter (6), dadurch **gekennzeichnet**, daß der Probenhalter (6) prismenförmig ist und einen von einer ersten Seitenfläche (7) des Prismas zu einer zweiten, angrenzenden Seitenfläche (8) verlaufenden Kanal (9) aufweist, der annähernd senkrecht zur ersten Seitenfläche (7) verläuft und der eingangsseitig mit einer Eintrittsblende (10) versehen ist und an dessen Ausgangsseite eine Membrane (5) mit den zu untersuchenden Strukturen parallel zur zweiten Seitenfläche (8) derart angebracht ist, daß die Membran-Rückseite in Richtung der zweiten Seitenfläche (8) des Prismas weist.

7. Vorrichtung nach Anspruch 6, dadurch **gekennzeichnet**, daß die beiden Flächen (7, 8), in denen die Kanalöffnungen liegen, einen Winkel einschließen, der annähernd so groß ist wie der Winkel zwischen Primärstrahl (14) und Beobachtungsrichtung.

8. Vorrichtung nach den Ansprüchen 6 und 7, dadurch **gekennzeichnet**, daß der Winkel α 60° beträgt.

9. Vorrichtung nach einem der Ansprüche 6 bis 8, dadurch **gekennzeichnet**, daß der Probenhalter (6) um eine Achse drehbar gelagert ist, die den Winkel α zwischen den Flächen (7, 8), in denen die Kanalöffnungen liegen, halbiert.

10. Vorrichtung nach einem der Ansprüche 6 bis 8, dadurch **gekennzeichnet**, daß durch Kippen des Probenhalters (6) Einfalls- und Ausfallswinkel optimiert werden können; so daß die Intensität im Spektrometer maximal wird.

11. Vorrichtung nach einem der Ansprüche 6 bis 9, dadurch **gekennzeichnet**, daß der Probenhalter (6) aus Metall, vorzugsweise Aluminium, besteht.

## Claims

1. Method of studying structures on membrane surfaces membranaires by means of photoelectron spectroscopy (XPS), wherein X-rays are released in a local zone of said membrane (5) for analysis by irradiation with a primary electron beam (14), said X-rays releasing, in their turn, photoelectrons (15) which are analyzed by means of a spectrometer (3),
**characterized** in that said primary electron beam (14) is incident on the rear side of said membrane (5) at a first predeterminable angle (δ) which is substantially different from 90°, and in that said photoelectrons which leave the membrane by its front side are observed at a second determinable angle ( ) which is substantially different from 90°, so that the angle between said incident electron beam (14) and the direction of observation ( ) is substantially smaller than 180°.

2. Method according to Claim 1, **characterized** in that the angle of incidence of said primary electron beam and the angle of observation of the secondary photoelectrons approximately coincide.

3. Method according to Claims 1 and 2, **characterized** in that the secondary electrons emitted from the rear side of said membrane are retained in a way that they will not reach said spectrometer (3).

4. Method according to any of Claims 1 to 3, **characterized** in that the electron energy of said primary beam (14) is reduced to a level so low that the electrons of said primary beam cannot leave said membrane by its front side.

5. Method according to any of Claims 1 to 3, **characterized** in that the electron energy of said primary beam (14) is increased to a level so high that primary and secondary (15) electrons leave said membrane by its front side, which are suitable to be used for the generation of a common electronic scanning image.

6. Apparatus for realizing the method according to any of Claims 1 to 5, formed by an apparatus for measuring Auger electrons, which comprises an electron source (1) and a photoelectron spectrometer (3), wherein the direction of the beam originating from said electron source and the direction of observation enclose an angle ( ) which is substantially smaller than 180°, and which additionally comprises a specimen holder (6), **characterized** in that said specimen holder (6) has the shape of a prism and includes a channel (9) passing from a first lateral surface (7) of the prism to a joining second lateral surface (8), which channel extends approximately vertically with respect to said first lateral surface (7) and is provided, at its input side, with an aperture (10), while, at the output side, a membrane (5) carrying the structures to be analyzed is mounted parallel with said second lateral surface (8) so that the rear membrane side faces towards said second lateral surface (8) of said prism.

7. Apparatus according to Claim 6, **characterized** in that said two surfaces (7, 8) in which the openings of said channel are located enclose an angle which is approximately equal to the angle between said primary beam (14) and the direction of observation.

8. Apparatus according to Claims 6 et 7, **characterized** in that said angle α amounts to 60°.

9. Apparatus according to any of Claims 6 to 8, **characterized** in that said specimen holder (6) is supported for rotation about un axis which is the bisector of said angle α between said surfaces (7, 8) in which are located the openings of said channel.

10. Apparatus according to any of Claims 6 to 8, **characterized** in that it is possible to optimize the angles of incidence and output by pivoting said specimen holder (6) in a way that the intensity in the spectrometer reaches a maximum value.

11. Apparatus according to any of Claims 6 to 9, **characterized** in that said specimen holder (6) consists of metal, preferably aluminium.

## Revendications

1. Procédé pour l'examen de structures sur des surfaces membranaires moyennant la spectroscopie photoélectronique (XPS), dans lequel on dégage des rayons X d'une zone locale de la membrane (5) à analyser par l'irradiation par un jet électronique primaire (14), lesquels rayons X dégagent, pour leur part, des photoélectrons (15) qui sont analysés moyennant un spectromètre (3),
**caractérisé** en ce que ledit jet électronique primaire (14) est incident sur la face arrière de ladite membrane (5) à un premier angle (δ) déterminable et essentiellement différent de 90°, et en ce que lesdits photoélectrons qui sortent de la face avant de la membrane sont observés à un deuxième angle ( ) déterminable et essentiellement différent de 90°, de façon que l'angle entre ledit jet électronique incident (14) et la direction d'observation ( ) soit essentiellement plus petit que 180°.

2. Procédé selon la revendication 1, **caractérisé** en ce que l'angle d'incidence dudit jet électronique primaire et l'angle d'observation des photoélectrons secondaires coïncident approximativement.

3. Procédé selon les revendication 1 et 2, **caractérisé** en ce que les électrons secondaires émis de la face arrière de ladite membrane sont retenus de façon qu'ils n'atteignent pas ledit spectromètre (3).

4. Procédé selon une quelconque des revendications 1 à 3, **caractérisé** en ce que l'énergie électronique dudit jet primaire (14) est réduit à un niveau si bas que des électrons du jet primaire ne puissent sortir de la face avant de ladite membrane.

5. Procédé selon une quelconque des revendications 1 à 3, **caractérisé** en ce que l'énergie électronique dudit jet primaire (14) est augmenté à un niveau si haut que des électrons primaires et secondaires (15) sortent de la face avant de ladite membrane, qui sont utilisables pour créer une image électronique tramée standard.

6. Dispositif pour réaliser le procédé selon une quelconque des revendications 1 à 5, constitué par un appareil pour mesurer d'électrons Auger, qui comprend une source d'électrons (1) et un spectromètre photoélectronique (3), la direction du jet provenant de ladite source d'électrons et la direction d'observation formant un angle ( ) qui est essentiellement plus petit que 180°, et comprenant de plus un porte-éprouvette (6), **caractérisé** en ce que ledit porte-éprouverte (6) est en forme de prisme et présente un canal (9) passant d'une première face latérale (7) du prisme vers une deuxième face latérale (8) contiguë, qui s'étend approximativement verticalement à ladite première face latérale (7) et est pourvu, du côté d'entrés, d'un écran (10), pendant qu'à son côté de sortie une membrane (5) portant les structures à analyser est montée en parallèle à ladite deuxième face latérale (8) de façon que la face arrière membranaire est dirigée en sens vers ladite deuxième face latérale (8) dudit prisme.

7. Dispositif selon la revendication 6, **caractérisé** en ce que lesdites deux surfaces (7, 8) dans lesquelles se trouvent les ouvertures dudit canal, forment un angle qui est approximativement égal à l'angle entre ledit jet primaire (14) et la direction d'observation.

8. Dispose selon les revendications 6 et 7, **caractérisé** en ce que ledit angle a se chiffre à 60°.

9. Dispositif selon une quelconque des revendication 6 à 8, **caractérisé** en ce que ledit porte-éprouvette (6) est logé pour une rotation autour un axe, qui bissecte ledit angle α entre lesdites surfaces (7, 8) dans lesquelles se trouvent les ouvertures dudit canal.

10. Dispositif selon une quelconque des revendications 6 à 8, **caractérisé** en ce qu'il est possible d'optimiser les angles d'incidence et de sorte par pivotement dudit porteéprouverte (6) de façon que l'intensité dans le spectromètre devienne maximale.

11. Dispositif selon une quelconque des revendications 6 à 9, **caractérisé** en ce que ledit porte-éprouvette (6) est fait en métal, de préférence en aluminium.
